# EUROPÄISCHE PATENTSCHRIFT

(11) **EP 0 561 184 B1**
(45) Veröffentlichungstag und Bekanntmachung des Hinweises auf die Patenterteilung: **03.01.1996**
(21) Anmeldenummer: 93102897.1
(22) Anmeldetag: 25.02.1993
(51) Int. Cl.: C25D 7/00

(54) **Einrichtung zur Behandlung von Gegenständen, insbesondere Galvanisiereinrichtungen für Leiterplatten**
Device for treating objects, especially electroplating device for circuit boards
Dispositif pour le traitement d'objets, en particulier dispositifs de métallisation pour plaques de circuit

(30) Priorität: 14.03.1992 DE 4208206; 15.04.1992 DE 4212567
(43) Veröffentlichungstag der Anmeldung: 22.09.1993
(73) Patentinhaber: Gebr. Schmid GmbH & Co., D-72250 Freudenstadt (DE)
(72) Erfinder: Schmid, Dieter C., W-7290 Freudenstadt (DE)
(74) Vertreter: Patentanwälte Ruff, Beier, Schöndorf und Mütschele

(56) Entgegenhaltungen:
- EP-A- 0 254 962
- EP-A- 0 351 569
- EP-A- 0 362 512
- EP-A- 0 365 767
- DE-A- 3 624 481
- DE-C- 2 845 886
- US-A- 3 970 540
- SOVIET INVENTIONS ILLUSTRATED, Sektion CH, Woche 3978, 08. November 1978, Derwent Publications Ltd., London (GB); Seite 8

## Beschreibung

Die Erfindung betrifft eine Galvanisiereinrichtung für Leiterplatten auf einer im wesentlichen horizontalen Durchlaufbahn durch eine Behandlungskammer.

Aus der EP-254 962 (entsprechend US-4 755 271) sowie aus der DE-36 24 481 A1 (entsprechend US-4 776 939) sind Galvanisiereinrichtungen bekannt geworden, bei denen Leiterplatten in horizontalem Durchlauf durch eine Behandlungskammer geführt werden. Am Rande der Behandlungskammer, ggf. durch eine Abschirmung getrennt, verlaufen Förderer, wie Kettenförderer, die die Leiterplatten zangenartig von der Seite greifen und so durch die Behandlungskammer führen. In dieser wird elektrolytisch Kupfer aufgetragen, wobei die Stromzuführung über die Zangen erfolgt. Bei Verwendung von Zangenführungen auf beiden Seiten könnte nur eine Leiterplattenbreite behandelt werden.

Aus der DE-32 36 545 C2 ist eine solche Einrichtung bekannt geworden, bei der die seitliche Führung der Leiterplatten durch hinter einer Abschirmung liegende Kontaktrollen erfolgt. An der anderen Seite der Leiterplatte kann eine Gleitführung vorgesehen sein.

Diese Anordnungen arbeiten nur mit Leiterplatten einer einheitlichen Größe zufriedenstellend. Werden Leiterplatten verwendet, die schmaler sind als die Durchlaufbahn, so laufen sie wegen ihrer einseitigen Führung und Kontaktierung unsymmetrisch durch die Behandlungskammer. Da die Behandlungsflüssigkeit, der Elektrolyt, kräftig bewegt wird, sind sie dann unsicher geführt oder Führungen auf der freien Seite müssen für jede Leiterplattenbreite gesondert eingestellt werden. Es ist also nicht möglich, mehrere Leiterplattengrößen wechselweise auf der Anlage zu behandeln. Die Unsymmetrie erfordert bei elektrolytischer Behandlung auch eine Teilabdeckung der Anoden, weil sonst der Galvanikauftrag über die Breite ungleichmäßig wird.

Aufgabe der Erfindung ist es, diese Nachteile zu vermeiden und insbesondere eine Einrichtung zu schaffen, die ohne Funktionsnachteile und ohne wesentliche Umrüstung auch unterschiedlich große Leiterplatten behandeln kann.

Diese Aufgabe wird durch den Anspruch 1 gelöst.

Die Kontaktiermittel, die die Gegenstände gleichzeitig auch durch die Behandlungskammer transportieren können, müssen also nicht seitlich angreifen, sondern können zentrisch oder weitgehend zentrisch um die Mittelachse verteilt angreifen. Sie können bei einer Ausführungsform aus mehreren nebeneinander auf einer Stange angeordneten zangenartigen Greifern bestehen, die über die Stange mit Strom versorgt werden, um den Gegenstand, insbesondere eine Leiterplatte, kathodisch anzuschließen und sie zwischen anodisch angeschlossenen Behältern mit Kupferkugeln o. dgl. hindurchlaufen zu lassen. Diese Kontaktierungsmittel können über Ketten, Zahnriemen oder dgl. zu beiden Seiten der Behandlungskammer auf einer horizontalen Bahn durch die Behandlungskammer laufen. Die Greifer können durch eine geeignete Mechanik, beispielsweise sich keilförmig verjüngende Führungsflächen am Beginn und am Ende der Durchlaufbahn, geöffnet werden. In die geöffneten Zangen werden die Gegenstände mittels eines anderen Teiles der Transportmittel, beispielsweise von Walzenpaaren, nach ihrer Einschleusung hineinbewegt. Der die Kontaktmittel tragende Endlosförderer, der bis zum Einführen der Gegenstände in die Zangen stillgesetzt oder verlangsamt wurde, läuft dann los, wobei sich die Greifer schließen. Am Ende der Behandlungskammer wird durch ähnliche Öffnungsmittel die Greifermechanik wieder geöffnet, die Greifer laufen vor der Leiterplatte her abwärts, um im Untertrum des Endlosförderers zurückgeführt zu werden, während die Leiterplatte zwischen Walzenpaaren wieder ausgeschleust wird.

Es ist somit möglich, beliebig große Leiterplatten ohne Umrüstung der Einrichtung zu behandeln und zentrisch an den Anoden vorbeizuführen. Auch bei anderen Behandlungsvorgängen ist dies vorteilhaft.

Die Walzenpaare, zwischen denen die von den Greifern gefaßten Gegenstände auf der Durchlaufbahn geführt werden, haben an ihrem Umfang Ausnehmungen, die durch Synchronenantrieb der Walzen und des Endlosförderers so zusammenwirken, daß sie die stangenförmigen Querträger, an denen die Greifer angeordnet sind, hindurchführen. Die Walzen haben dadurch einen etwa malteserkreuzartigen Querschnitt.

Durch die Greifer, von denen mehrere an einem Gegenstand angreifen können, ist die Kontaktierung sehr gut. Bis auf die reinen Kontaktflächen können die übrigen Teile der Mechanik aus nichtleitenden Materialien hergestellt oder mit diesen ummantelt sein. Soweit allerdings auf die Kontaktflächen selbst infolge der Galvanisierung Material aufgetragen wird, kann dies beim Rücklauf, das ebenfalls in der Behandlungskammer, und zwar unterhalb der Durchlaufbahn erfolgt, galvanisch wieder entfernt werden. Dazu können die Greifer durch entsprechend lange Öffnungsmittel in Form von die Greifer öffnenden Schienen offengehalten werden.

Da die Ketten und die Stromzuführungsmittel für die Querträger, d. h. die Kontaktschienen, möglichst nicht in der Behandlungsflüssigkeitlaufen sollten, ist zwischen ihnen und der eigentlichen Behandlungskammer eine Abschirmung bzw. Abdichtung vorgesehen. Diese kann durch Labyrinthdichtungen, Bürsten, elastische Dichtstreifen o. dgl. geschehen. Da die Querträger in ihrer Formgestaltung frei sind, können sie, insbesondere an dieser Stelle, so ausgebildet sein, daß sie am günstigsten mit den Abdichtmitteln zusammenwirken.

Für die vorher beschriebene Entkupferung ist es zwar vorteilhaft, wenn das Rücktrum des Endlosförderers in der Behandlungskammer unterhalb der Behandlungsbahn verläuft. Es kann aber beispielsweise die Abdichtung vereinfachen, wenn das Rücktrum als Obertrum ausgebildet ist, d. h oberhalb des Behälters und damit des Flüssigkeitspiegels verläuft.

Um die Leiterplatten auf der vorteilhaften horizontalen Durchlaufebene zu transportieren und sie in die Greifer einlaufen und von diesen wieder freikommen zu lassen, ist eine Steuerung vorgesehen, die durch Unterschiede in der Geschwindigkeit zwischen den Kontaktiermitteln, d. h. dem Endlosförderer, auf dem die Greifer angeordnet sind, und den Zuführ- und Entnahmemitteln, d. h. den Förderabschnitten, die die Gegenstände ein- und wieder ausschleusen, eine Zusammenführung bzw. Trennung der Gegenstände von den Greifern ermöglicht. Dies kann dadurch geschehen, daß der Endlosförderer mit einer geöffneten Greiferreihe in der Einführposition stoppt und erst wieder anläuft, wenn ein Gegenstand, d. h. eine Leiterplatte, in den Greifer eingeführt ist und schließlich im Auslaufbereich nach Öffnen der Greifer diese vor der auszuschleusenden Leiterplatte hinweglaufen. Es ist aber auch möglich, bei konstant durchlaufendem Endlosförderer (was für die Galvanisierung vorteilhaft wäre) durch gezielte Beschleunigung bzw. Verzögerung der Leiterplatten im Ein- bzw. Auslaufbereich zu erreichen, daß die Gegenstände die Kontaktiermittel genau zu dem Zeitpunkt erreichen, wenn diese sich schließen. Vor dem Ausschleusen könnten von dem Endlosförderer unabhängig oder nur bedingt abhängig antreibbare Antriebsmittel, beispielsweise Walzensätze, vorgesehen sein, die die Leiterplatte kurz zurückhalten, so daß sie aus dem Greifer freikommen und diese dann in kurzem Abstand hinter dem Greifer in Richtung Ausschleusung weiter transportieren. Dies kann beispielsweise durch eine elektronisch von Sensoren für die Gegenstände, beispielsweise für deren Vorderkante, steuerbare elektrische Antriebsmittel geschehen oder auch durch mechanische Einrichtungen, wie Kurven- oder Ungleichförmigkeitsgetriebe.

Bei einer besonders bevorzugten Ausführungsform der Erfindung können die Kontaktiermittel zum Transport der Gegenstände mit höherer Geschwindigkeit als der der Kontaktiermittel ausgebildet sein. Damit ist sowohl der Gegenstand als auch das Kontaktiermittel beweglich und das letztere kann einer beliebigen, galvanischen ätzenden oder sonstigen Entkupferung zugeführt werden.

Die Kontaktiermittel können dabei Kontaktrollen sein, die von den Transportmitteln längs der Durchlaufbahn bewegt werden. Sie können den Mittelbereich der Gegenstände übergreifen und oberhalb und unterhalb der Durchlaufbahn angeordnet sein. Wenn sie selbst in Durchlaufrichtung transportierend angetrieben und vorzugsweise gegenläufig synchronisiert sind, dann fördern sie die Leiterplatten zwischen sich mit der gleichen Geschwindigkeit hindurch, mit der sie selbst angetrieben sind, so daß die Leiterplatten dann die doppelte Fördergeschwindigkeit der Kontaktrollen haben.

Die Kontaktrollen können ihrerseits an oberen und unteren Ketten- oder Riemenförderern angebracht sein und mittels Kontaktschienen kontaktiert werden. Die Kontaktschienen können auch im Zusammenhang mit Kontakträdern, die ihrerseits an den Kontaktrollen-Achsen vorgesehen sind, den Drehantrieb bewirken.

Die Kontaktrollen, die im Wechsel leitende und isolierende Bereiche enthalten können, können die Leiterplattenflächen großflächig und auch über eine große Breite kontaktieren, so daß die Leitung der nicht unerheblichen Galvanisierungsströme durch die teilweise sehr dünnen leitenden Schichten kein Problem darstellt. Sie können relativ dicht angeordnet sein und somit eine größere Leiterplatte auch mehrfach im Bereich ihrer Länge kontaktieren. Sie bilden vor allem eine ideale Führung der Gegenstände, die damit auf keine weiteren Führungshilfsmittel angewiesen sind.

Diese und weitere Merkmale gehen außer aus den Ansprüchen auch aus der Beschreibung und den Zeichnungen hervor.

Ausführungsbeispiele der Erfindung sind in den Zeichnungen dargestellt und werden im folgenden näher erläutert. Es zeigen:
- Fig. 1a + b: zwei zusammengehörige Abschnitte einer Galvanisiereinrichtung im schematischen Längsschnitt,
- Fig. 2: eine Draufsicht auf einen Abschnitt der Galvanisiereinrichtung,
- Fig. 3: einen Teilschnitt entlang der Linie III,
- Fig. 4: eine schematische Darstellung einer Variante,
- Fig. 5: einen schematischen Längsschnitt durch eine weitere bevorzugte Ausführungsform einer Galvanisiereinrichtung,
- Fig. 6: eine Draufsicht auf einen Abschnitt der Galvanisiereinrichtung nach Fig. 5,
- Fig. 7: einen Schnitt durch ein Detail nach der Linie VII in Fig. 6 und
- Fig. 8: eine teilgeschnittene Ansicht nach der Linie VIII in Fig. 7.

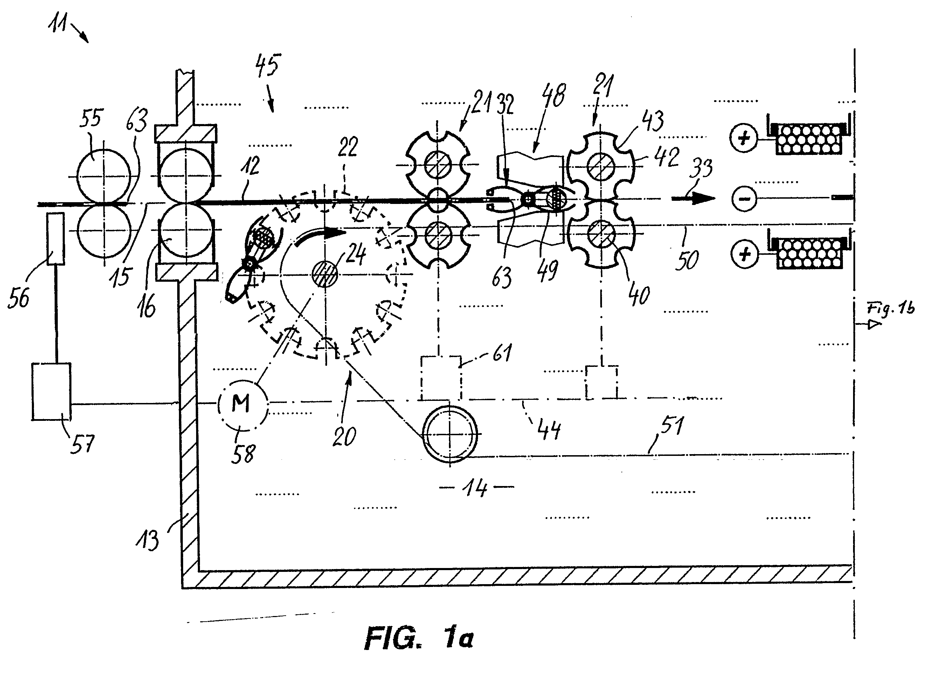

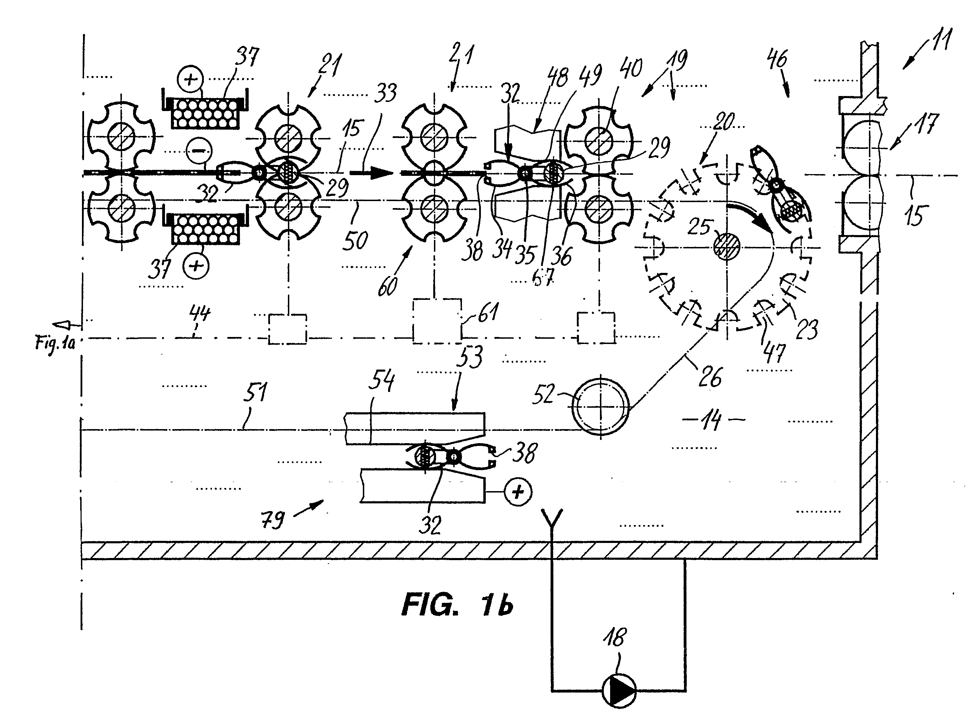

Fig. 1 zeigt eine Galvanisiereinrichtung 11 für plattenförmige Gegenstände 12, wie elektrische Leiterplatten. Sie weist eine langgestreckte Behandlungskammer 13 in Form eines Behälters auf, in dem das Behandlungsmedium 14, eine Elektrolytlösung, enthalten ist.

Die Gegenstände werden auf einer in einer horizontalen Ebene liegenden Durchlaufbahn 15 durch die Behandlungskammer geführt und durch Einlaß- und Auslaßschleusen 16, 17 in Form von Walzensätzen ein- und ausgeschleust. Das Behandlungsmedium 14 steht höher als diese Schleusen. Es wird durch eine schematisch angedeutete Pumpe 18 umgewälzt und dabei auf Dichte, Zustand und Temperatur überwacht.

Die Leiterplatten 12, die in der schematischen, auch bezüglich der Länge der Anlage wesentlich verkürzten Darstellung, teilweise kürzer dargestellt sind, als sie in Wirklichkeit sind, werden von Transportmitteln 19 durch die Galvanisiereinrichtung bewegt, die beim Ausführungsbeispiel einen Endlosförderer 20 und Führungsmittel 21 in Form von zusammenwirkenden Rollen- oder Walzensätzen enthalten. Die Führungsmittel und der Endlosförderer sind auf die noch beschriebene Weise synchron angetrieben.

Der Endlosförderer 20 ist ein Kettenförderer mit je einem einlaß- und einem auslaßseitigen Kettenrad 22, 23 auf jeder Kammerseite. Sie sind auf Wellen 24 gelagert und treiben je eine Kette 26 an, die seitlich außerhalb der eigentlichen Kammerwandung 27 läuft.

Auf den Ketten sind Tragglieder 28 vorgesehen, an denen Querträger 29 in Form je einer Stange angebracht sind. Sie ragen durch Schlitze 31 in der Kammerwandung 27 hindurch, die durch übliche Dichtungen 30 in Form von Labyrinthen in Mehrkammerbauweise, Bürsten, elastischen Dichtleisten o. dgl. abgedichtet sind, und ragen durch die gesamte Behandlungskammer hindurch. Auf dem Querträger 29 sind über die Breite der Behandlungskammer in gleichmäßigem Abstand mehrere, beispielsweise sechs, Kontaktiermittel 32 in Form von Greifern oder Zangen angeordnet, deren Greifschenkel 34 entgegen der Durchlaufrichtung (Pfeil 33) weisen. An den Greifschenkeln 34 sind Betätigungsschenkel vorgesehen, die, in der Mitte von einer horizontalen Achse 35 geführt, sich dort kreuzen, so daß bei einem Zusammendrücken der Betätigungsschenkel 36 nach Art einer Kombizange die Greifschenkel öffnen. Eine Feder 67 hält sie normalerweise federnd geschlossen.

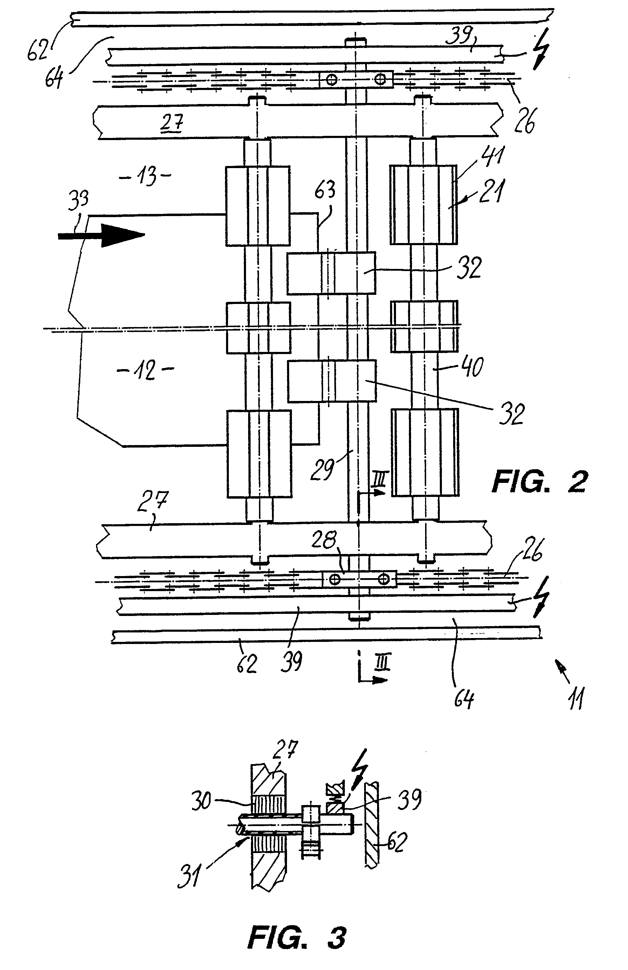

Alle in der Behandlungskammer befindlichen Teile mit Ausnahme von Anoden 37 in Form von Körben mit Kupferstücken, die oberhalb und unterhalb der Durchlaufbahn 15 vorgesehen sind, und den Kontaktflächen 38 der Greifschenkel sind alle Teile innerhalb der Behandlungskammer aus nichtleitenden Materialien, wie Kunststoffen, angefertigt oder mit diesen beschichtet. Die elektrisch leitenden Kontaktflächen der Kontaktiermittel sind leitend mit dem Querträger 29 verbunden und dieser leitet ihnen Strom zu, der beim Ausführungsbeispiel über seitliche Kontaktschienen 39 (Fig. 2 und 3), die außerhalb der Ketten 26 verlaufen, zugeführt werden. Die Stromzuführung könnte auch über die Ketten oder die Tragglieder 28 direkt erfolgen.

In einem Abstand voneinander, der normalerweise kleiner ist als eine Leiterplattenlänge, sind die die Führungsmittel 21 bildenden Walzensätze angeordnet. Sie enthalten je auf einer oberen und einer unteren Antriebswelle 40 angeordnete Walzenabschnitte 41, die im Querschnitt malteserkreuzartig ausgebildet sind. Ihr im übrigen kreiszylindrischer Mantel 42 hat halbrunde Ausnehmungen 43, die in ihrer Form zu dem beim Ausführungsbeispiel kreisrunden Querschnitt der Querträger 29 passen. Sie sind mit dem Endlosförderer 20 so synchron angetrieben, daß einerseits ihre Umfangsgeschwindigkeit im Bereich des Mantels 42 mit der Transportgeschwindigkeit der Querträger 29 übereinstimmt und andererseits diese Querträger von den Ausnehmungen 43 umfaßt werden, so daß sie die im übrigen federnd aufeinanderliegend bzw. nur einen geringfügigen Abstand voneinander habenden Walzenpaare passieren können. Dazu sind sie über einen nicht dargestellten, im Bereich der Kammerwandung 27 vorgesehenen Synchronantrieb angetrieben, beispielsweise über Ketten, Stirnräderreihen oder eine durchlaufende Synchronwelle 44 (in Fig. 1 angedeutet) mit Kegelrädern. Der Antrieb der Synchronwelle ist vom Antrieb des Endlosförderers mechanisch oder elektrisch abgeleitet. Die Kettenräder 22, 23 sind so ausgebildet, daß die Querträger in den entsprechend großen Zahnlücken 47 aufgenommen werden.

Angrenzend an den Einlaßbereich 45 und den Auslaßbereich 46 sind Öffnungsmittel 48 angeordnet, die aus je einer oberhalb und unterhalb der Durchlaufbahn angeordneten Führungsschienen bestehen, die in Durchlaufrichtung sich trichterartig verjüngen. Die Öffnung könnte auch durch unmittelbare Betätigung, z. B. durch Pneumatikzylinder, erfolgen. Sie arbeiten mit den Betätigungsschenkeln 36 der Kontaktiermittel 32 zusammen und öffnen diese beim Einlaufen. In einem an die Verjüngung anschließenden parallelen Abschnitte 49 bleiben die greiferartigen Kontaktiermittel geöffnet.

Der dargestellte Endlosförderer 20 enthält die Durchlaufbahn 15 für die zu behandelnden Gegenstände 12 im Bereich, und zwar in der Praxis etwas oberhalb, seines oberen Kettentrums 50, das zwischen den einlaß- und auslaßseitigen Umlenkrädern 22, 23 verläuft. Die Rückführung erfolgt über ein parallel darunterlaufendes Rückführtrum 51, das zwischen unteren Umlenkrädern 52 verläuft. Im Bereich des Untertrums 51 sind ebenfalls Öffnungsmittel 53 vorgesehen, deren zylindrischer Abschnitt 54 allerdings wesentlich länger ist und fast über die Gesamtlänge des Untertrums verlaufen kann. In diesem eine Einrichtung 79 zum Entfernen störender Beschichtungen (Entkupferungseinrichtung) bilden Bereich werden die Querträger durch außerhalb der Behandlungskammer liegende Kontaktschienen ebenfalls kontaktiert, jedoch dort mit umgekehrter Polarität (anodisch), so daß die durch die Öffnung der Kontaktiermittel freiliegenden Kontaktflächen 38 der Greifer nun als Anode wirken und evtl. auf ihnen vorgesehener Galvanikbelag anodisch entfernt wird.

Im Einlaßbereich werden die Leiterplatten durch außerhalb des Behandlungsraums liegende Rollenpaare 55 zugeführt. In diesem Bereich ist ein Sensor 56 angeordnet, der beispielsweise auf die Vorderkante 63 der Gegenstände 12 ansprechen kann. Er ist mit einer Steuerung 57 verbunden, die den Antrieb des Endlosförderers und/oder einzelner Walzenpaare der Führungsmittel 21 im Eingangs- und Ausgangsbereich 45, 46 steuert.

Die Einrichtung arbeitet nach folgendem Verfahren:

Die Gegenstände 12 (Leiterplatten) werden im Eingangsbereich durch die Einführ-Rollenpaare 55 herangefördert, wobei ihre Vorderkante den Sensor 56 auslöst. Sie werden durch die angetriebenen Walzen der Einlaßschleuse 16 beschleunigt und in die Behandlungskammer eingeführt, wo sie von den ersten Führungsmitteln 21, die ggf. mit einer Überholkupplung versehen sind, erfaßt und geführt werden. Sie werden dann von im Behandlungsraum angeordneten Rollenpaaren 59 übernommen und zwischen die geöffneten Greifschenkel der Kontaktiermittel an einem Querträger hineingeführt.

Zu diesem Zweck kann der Endlosförderer bei der Einführung einer Leiterplatte - durch die Steuerung 57 gesteuert - kurz gestoppt werden, und zwar genau an einer Stelle, an der die Kontaktiermittel (Greifer 32) des Querträgers geöffnet sind, weil ihre Betätigungsschenkel 36 im Bereich der parallelen Abschnitte 49 stehen. Danach läuft der Endlosförderer 20 wieder an, die Greifschenkel der Kontaktiermittel schließen sich und kontaktieren die leitend vorbereiteten Bereiche auf der Oberfläche der Leiterplatte. Über die Querträger und die Leiterschienen 39 ist damit die Leiterplatte kathodisch (minus) kontaktiert und wird so auf der ebenen Durchlaufbahn 15 durch die Behandlungskammer und damit zwischen den Anoden hindurchgeschleppt. Sie ist dabei von den Kontaktiermitteln nicht nur elektrisch kontaktiert, sondern auch gehalten und wird außerdem durch die Führungsmittel 21 geführt, gestützt und mit vorwärts transportiert. Die elektrisch kontaktierenden Greifer laufen also in der gleichen Ebene und in der Bewegungsbahn der Gegenstände vor diesen her.

Während des Durchlaufen des eigentlichen Galvanisierbereiches, d. h. zwischen den Anoden 37 hindurch, laufen die Leiterplatten über nicht dargestellte Schwalldüsen hinweg, die das Behandlungsmedium von unten her gegen die Leiterplatten und vor allem durch die relativ kleinen Bohrungen in den Leiterplatten hindurchdrücken, um auch eine einwandfreie Galvanisierung im Lochbereich sicherzustellen.

Es ist vor allem aus Fig. 2 zu erkennen, daß die Leiterplatte auf jeder beliebigen Position der Bahnbreite, vorzugsweise aber zentral zu der Mittelebene der Behandlungskammer, geführt werden kann, wobei es gleichgültig ist, wie breit die jeweilige Leiterplatte ist. Es ist auch möglich, unterschiedliche Leiterplattenbreiten in beliebigem Wechsel zuzuführen, ohne daß diese zentrale Ausrichtung verlassen werden muß. Wenn dabei nur einige der über die Breite der Behandlungskammer vorgesehenen Kontaktiermittel die Leiterplatte ergreifen, so ist dies unbedeutend, weil die übrigen Kontaktflächen sich dann unter der Federkraft schließen und somit vor einer Aufgalvanisierung weitgehend abgeschirmt sind.

Beim Transport auf der Durchlaufbahn laufen durch die Synchronisation zwischen den Führungswalzenpaaren 21 und dem Endlosförderer die Querträger 29 reibungslos zwischen den Walzen hindurch. Im Auslaßbereich 46 laufen die Kontaktiermittel wiederum in ein Öffnungsmittel 48 ein und werden geöffnet. In diesem Bereich kann nun die Leiterplatte, z. B. durch kurzfristiges, gezieltes Abkuppeln des vor dem Öffnungsbereich liegenden Führungswalzenpaares 60 oder durch eine entsprechende Beschleunigung des Endlosförderers, die Leiterplatte nach dem Öffnen der Kontaktmittel aus deren Greifschenkel herausgezogen werden. Danach kann die Weiterförderung wieder in gleicher Geschwindigkeit einsetzen und die Leiterplatte kann, dem Kontaktiermittel folgend, in Richtung Auslaßschleuse 17 und aus dieser hinaus transportiert werden. Hier könnte beispielsweise durch ein besonderes Schaltgetriebe 61 in Abhängigkeit von der Steuerung 57 das Walzenpaar, teilungsgerecht, z.B. für eine Viertelumdrehung, angehalten werden, so daß es nach Aufhebung dieses Stillstands wieder in der vorher beschriebenen Synchronität mit den Endlosförderer weiterläuft. Das gleiche könnte mit umgekehrtem Vorzeichen, d. h. mit einem beschleunigten Vorwärtstakten des ersten Walzenpaares im Einlaßbereich 35 geschehen, um die Leiterplatte zwischen die Greifschenkel einzuführen.

Nach dem Verlassen des auslaßseitigen Öffnungsmittels schließt sich die Zange unter der Federkraft wieder und läuft auf dem Untertrum zurück, wobei sie dort zwischen den Schienen 54 für längere Zeit geöffnet und zur Entkupferung anodisch angeschlossen wird.

Das Behandlungsmedium, die Galvaniklösung, wird ständig umgewälzt und auch aus dem "halbtrockenen" Bereich 64 zwischen der eigentlichen Kammerwandung 27 und einer Außenwandung 62 (Fig. 2 und 3) zurückgeführt, so daß es auf eine vollständige Abdichtung durch die Dichtungen 30 nicht ankommt. Das gleiche gilt für im Schleusenbereich austretende Leck-Flüssigkeit.

Von dem vorstehend anhand einer schematischen Zeichnung beschriebenen Ausführungsform sind zahlreiche Abwandlungen möglich. So kann beispielsweise das gesamte Transportsystem für die Gegenstände in Abhängigkeit von dem Signal eines außenliegenden Sensors und von den unterschiedlichen Transportgeschwindigkeiten über eine Steuerung 57 durchgeführt werden. Es ist aber auch möglich, andere Signale zur Steuerung zu verwenden, beispielsweise vom Passieren der Gegenstände durch einzelnen Walzenpaare ausgelöste Signale oder dgl..

Es ist zu erkennen, daß die Führungswalzenpaare 21 so angeordnet sind, daß bei benachbarten Walzen jeweils zwei Umfangsabschnitte im Leiterplatte kontaktierenden Bereich liegen, wenn bei dem benachbarten walzenpaar gerade zwei Ausnehmungen sich gegenüberstehen. Da eine Leiterplatte möglichst immer von zwei Walzenpaaren gleichzeitig erfaßt wird, ist damit eine sichere Führung möglich. Die Walzenpaare können auch selbstanpassend durch Gewicht oder Federkraft in Kontakt auch zu unterschiedlichen Leiterplattendicken gehalten werden. Es ist aber auch möglich, insbesondere im Einlaßoder Auslaßbereich die Stelle, an denen die beiden Ausnehmungen gegenüberliegen, und in denen der Kontakt zwischen Walzen und Leiterplatte momentan nachläßt, wenn die Walzen fest gelagert werden, zu benutzen, um die Leiterplatte gegenüber der Umfangsgeschwindigkeit der Walzen kurz zu beschleunigen oder zu verzögern, um sie zwischen die Zangen zu schieben oder aus diesen herauszuziehen. Dazu können die Walzenpaare 55 auch voneinander abgehoben werden oder mit einem Freilauf versehen sein.

Es wird also eine Galvanisiereinrichtung für Leiterplatten geschaffen, die ein Transportsystem 19 besitzt, von dem die Leiterplatten auf einer horizontalen Durchlaufbahn durch die Behandlungskammer 13 hindurchgeführt werden. Sie werden von zangenartigen Greifern 32 kontaktiert, die vor der Vorderkante 63 der Leiterplatte laufen und in diesem Bereich von oben und unten auf sie herauffassen. Die Greifer 32 sind an Querträgern 29 befestigt, die beidseitig durch Ketten 26 geführt und durch Kontaktschienen 39 elektrisch kontaktiert werden. Die Leiterplatten 12 werden also in einer horizontalen, zentrischen Bahn geschleppt und gleichzeitig kontaktiert.

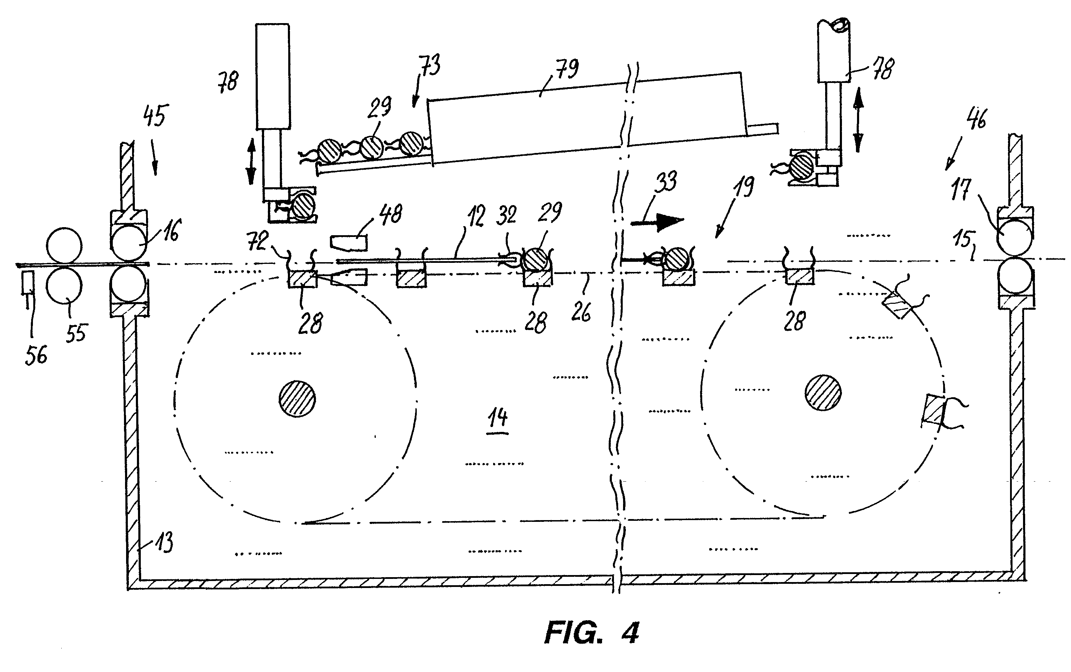

In Fig. 4 ist eine Variante schematisch dargestellt, bei der bei im übrigen gleicher Ausbildung und Funktion wie vorher beschrieben, die Träger 29 nicht ständig an den Traggliedern 28 der Kette 26 befestigt sind, sondern dort mit einer automatisch arbeitenden Haltevorrichtung 72, beispielsweise einer Schnappbefestigung anbringbar sind. Die Träger werden dort durch eine aneinander angepaßte Gestaltung von Träger 29 und Haltevorrichtung 72 auch in einer bestimmten Lage, nämlich mit entgegen der Durchlaufrichtung 33 weisenden Kontaktiermitteln 32 an den Traggliedern 28 angebracht. Die Tragglieder 28 sind im Gegensatz zu der Ausführung nach den Fig. 1 bis 3 in geringerem Abstand voneinander an der Kette angebracht.

Bei dem dargestellten Ausführungsbeispiel oberhalb der Durchlaufbahn 15 ist eine Rückführ- und Speichereinrichtung 73 für die Träger 29 mit den Kontaktiermitteln 32 gezeigt, beispielsweise als eine schräge Rutsche, auf der die Träger von dem Auslaßbereich 46 zum Einlaßbereich 45 zurückgeführt werden. Eine Greifeinrichtung 78 ist im Einlaß- und Auslaßbereich vorgesehen, die dort jeweils einen Träger zwischen der Rückführ- und Speichereinrichtung 73 und zwei zusammengehörigen Traggliedern auf dem Förderer (je einer rechts und links) hin und her transportiert. Ein Träger 29 wird also nach Bedarf im Einlaßbereich 45 in ein Traggliederpaar 28 eingesetzt, dort durch die Haltevorrichtung befestigt und im Auslaßbereich wieder entnommen und auf die Rückführ- und Speichereinrichtung zurückgesetzt. Im Bereich der Rückführund Speichereinrichtung kann eine Entkupferungseinerichtung 79 gesondert vorgesehen sein. Es ist aber auch möglich, die Rückführung im Bereich des Untertrums der Kette vorzusehen und dort die Entkupferung vorzunehmen.

Diese Vorrichtung arbeitet wie folgt:

Die Leiterplatten werden, wie vorher beschrieben, durch die Einlaßschleuse 16 eingeschleust. Der Sensor 56 gibt dabei das Signal für die Greifervorrichtung 78, einen Träger 29 mit Kontaktiermitteln 32 in die Haltervorrichtungen 72 von Traggliedern 28 der Kette einzusetzen, die gerade der Einlaßschleuse benachbart sind. Der weitere Verfahrensablauf ist dann wie anhand von der Fig. 1 bis 3 beschrieben. Der Sensor 56, oder auch gesonderter Sensor, kann auch die Hinterkante der Leiterplatte ermitteln und daraus ihre Länge feststellen. In Abhängigkeit von diesem Signal erfolgt die Steuerung. Wenn die Leiterplatte kürzer ist als der Abstand zwischen zwei aufeinanderfolgenden Traggliedern 28 abzüglich der Konstruktionslänge der Kontaktiervorrichtung, dann wird die nächste Leiterplatte schon so eingeschleust, daß der ihr zugehörige Träger bereits in das nächste Traggliederpaar eingesetzt wird. Ist die Leiterplatte jedoch länger, so werden ein oder ggf. mehrere Tragglieder übersprungen. Auf diese Weise wird eine flexible und auch bei der Aufeinanderfolge unterschiedlicher Leiterplatten möglichst lückenlose Belegung der Vorrichtung erreicht.

Im Endbereich der Einrichtung wird, nachdem die Kontaktiermittel durch die Öffnungsmittel 48 geöffnet und die Leiterplatte aus ihr herausgezogen wurde, der Träger 29 von der Greifeinrichtung 78 erfaßt und unter Öffnung der Haltemittel, z. B. durch Ausschnappen aus den Traggliedern, nach oben abgezogen und auf die Rückfür- und Speichereinrichtung aufgelegt. Von dort kann sie beispielsweise durch Schwerkraft oder andere Fördermittel wieder zum Eingangsbereich zurückgeführt werden. Es ist auch möglich, daß Öffnen und Schließen der zangenartigen Kontaktiermittel durch die Greifereinrichtung 78 steuern zu lassen. In diesem Falle könnten die gesonderten Öffnungsmittel 48 am Ein- und Auslaß entfallen.

Wenn eine Behandlung in mehreren aufeinanderfolgenden Bädern stattfindet, so könnte im Auslaßbereich 46 der Träger 29 auch zusammen mit der Leiterplatte und in die darauffolgende Vorrichtung wieder eingeschleust werden. Dies kann entweder durch entsprechend ausgebildete Schleusen 16, 17, erfolgen oder aber auch dadurch, daß die Greifvorrichtung 78 den Träger zusammen mit der Leiterplatte erfaßt und in die nächste Behandlungskammer, über deren Wandungen hinweg, überführt. Dabei sollte jedoch für eine entsprechende Abstützung der Leiterplatten gesorgt werden.

Die Rückführung der Träger erfolgt dann über die aufeinanderfolgenden Behandlungskammern hinweg. Die Rückführ- und Speichereinrichtung bildet einen Zwischenspeicher für Träger, von denen so viel vorgesehen sein können, wie überhaupt maximal benötigt werden. Bei geringerer Belegung wegen längerer Leiterplatten bildet sich dann auf der Rückführ- und Speichereinrichtung ein Stau, der diese Unterschiede ausgleicht.

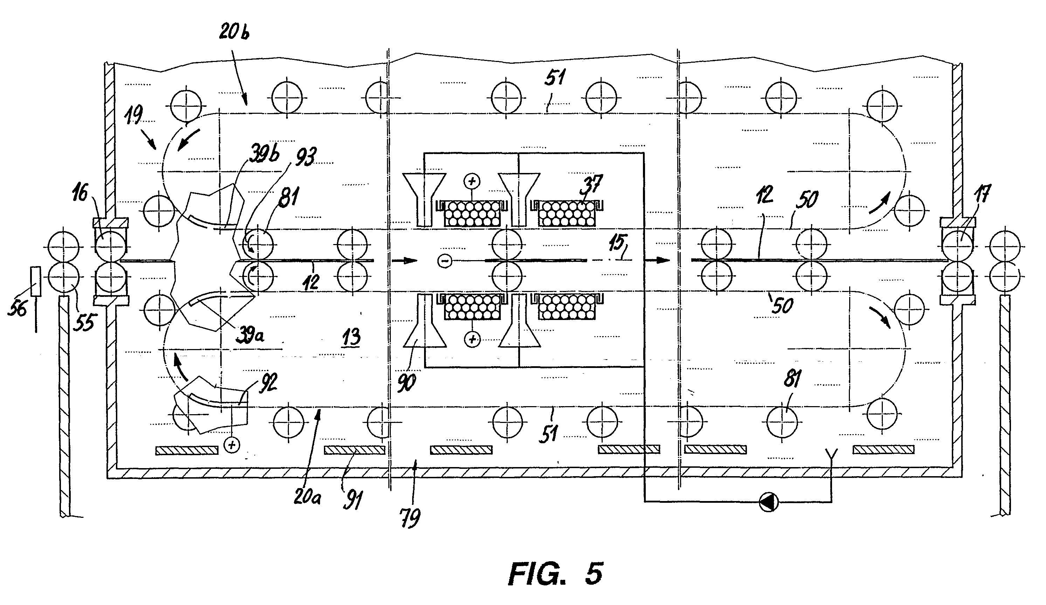

Bei der Ausführungsform nach den Figuren 5 bis 8 sind gleiche Merkmale mit gleichen Bezugszeichen versehen wie in den vorhergehenden Zeichnungen. Auf ihre nochmalige Beschreibung wird verzichtet.

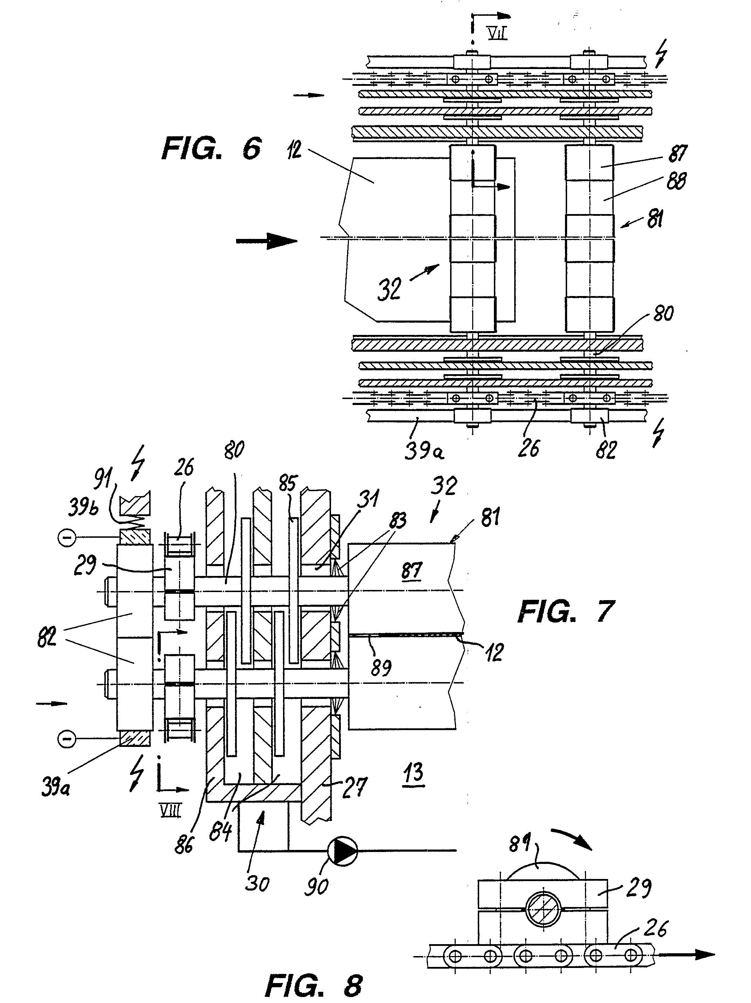

Die Transportmittel 19 sind zwei Endlosförderer 20a, b, die oberhalb und unterhalb der Durchlaufbahn 15 angeordnet sind. Dargestellt sind Kettenförderer, an deren Kettengliedern in Abstand voneinander Träger 29 angebracht sind (siehe Fig. 6 bis 8). In den Trägern sind drehbar Achsen 80 von die Kontaktiermittel 32 bildenden Kontaktrollen 81 gelagert. Die Kontaktrollen tragen an ihren freien Enden, d. h. an der von der Behandlungskammer 13 abgewandten Seite der Träger 29, Kontakträder 82, die auf unteren und oberen Kontaktschienen 39a, b abrollen und von dort elektrisch kontaktiert werden. Wenigstens eine der Kontaktschienen kann abgefedert sein, was durch eine Federung 90, z. B. der obersten Kontaktschiene, dargestellt ist. Sie übt so einen die Kontakträder 82 und/oder die Kontaktrollen gegeneinander andrückenden Kontaktdruck aus. Die Kontakträder, im Beispiel Reibräder, rollen auf den Kontaktschienen und normalerweise auch aufeinander ab, so daß sie die Kontaktrollen 81 gegenläufig synchronisiert antreiben. Wenn dickere Leiterplatten 12 in den Spalt 89 zwischen den Kontaktrollen 81 einlaufen, heben die Kontakträder 82 voneinander ab, was durch die Federung 91 möglich ist. Die Synchronisation bleibt aber durch Abrollen der Kontakträder 82 auf den Kontaktschienen 39a, b sichergestellt. Es ist aber auch möglich, die Anpassung der Spaltdicke durch Flexibilität anderer Bauteile, z. B. der Kontakträder, -rollen oder ihrer Achsen, zu ermöglichen.

Die Kontaktschienen können auch als Zahnstangen ausgebildet sein, wobei dann die Kontakträder 82 als ineinander und in der Zahnstange kämmende Räder ausgebildet wären. Sie könnten ihren Eingriff zumindest beim Durchlauf dünnerer Leiterplatten beibehalten. Insbesondere bei dieser Ausführung wäre es auch möglich, mit nur einer Kontaktschiene zu arbeiten, wobei dann die Stromübertragung über die Zahnräder auf die von der Kontaktschiene entfernte Kontaktrolle erfolgen würde. In jedem Falle ist sichergestellt, daß die Bearbeitung unterschiedlich dicker Leiterplatten möglich ist, d. h. eine Änderung der Breite des Spalts 89 zwischen den Kontaktrollen 81, ohne daß der Kontakt der Kontakträder miteinander oder mit den Kontaktschienen verloren geht.

Die Achsen 80 laufen durch Schlitze 31 in der Kammerwandung 27 hindurch. Als Dichtung 30 ist eine kombinierte Labyrinth-Bürstendichtung eingesetzt. Sie enthält Bürsten 83 oder elastische Leisten an der Innenseite der Kammerwandung 27 und ein zwei- oder mehrkammriges Labyrinth-System 84, das jeweils bei benachbarten Achsen 80 gegeneinander versetzt angeordnete Scheiben 85 aufweist, die die betreffenden Schlitze in den Kammer- und Zwischenkammerwandungen 27, 86 überdecken und auch entsprechenden Anschluß an das vorhergehende und darauffolgende Wellenpaar haben. Auf diese Weise können auch die relativ langen und großen Schlitze ohne wesentlichen Flüssigkeitsübertritt abgedichtet werden und die Kette sowie die Kontakträder laufen im fast trockenen Bereich. Das durch das Labyrinth-System 84 dringende Behandlungsmedium wird in die Behandlungskammer oder einen Tank zurückgeführt, wie mit dem Rückführungssystem 90 (Fig. 7) angedeutet ist.

Die Kontaktrollen 81 haben in Längsrichtung abwechselnde leitende Abschnitte 87 und isolierende, beispielsweise aus Kunststoff bestehende Abschnitte 88. Durch entsprechende Durchmesserunterschiede zwischen diesen Abschnitten und/oder die Wahl eines entsprechenden Kunststoffmaterials ist sichergestellt, daß eine gute und flächige Kontaktierung der durch den Spalt 89 zwischen den beiden Kontaktrollen laufenden Leiterplatten von beiden Seiten erfolgt und die Galvanisierung in den nicht kontaktierten Bereichen nicht behindert.

Wie Fig. 5 zeigt, laufen die beiden Endlosförderer zueinander parallel und sind gegenläufig angetrieben. Der Abstand von benachbarten Trägern 29 auf der gleichen Kette 26 kann relativ gering sein. Er liegt zwischen dem 1,5- und fünffachen, bevorzugt zwischen dem zwei- und dreifachen des Kontaktrollendurchmessers. So ist eine hervorragende Kontaktierung und gute Führung sichergestellt.

Im Bereich der Anoden 37 sind Schwalldüsen 90 angeordnet, die einen Strom des Behandlungsmediums 14 auf die Leiterplatten 12 lenken und damit eine gute Durchflutung auch von Bohrungen etc. ermöglichen.

Im unteren Teil der Behandlungskammer 13 ist eine Entkupferungsstrecke 79 dargestellt, die noch mit zusätzlichen Hilfskathoden 91 arbeitet. Aus diesem Grunde ist im Bereich des rücklaufenden, beim unteren Förderer untere Trums 51 auch eine Kontaktschiene 92 vorgesehen, die jedoch anodisch angeschlossen ist. Die Kontaktrollen werden dadurch während der Entkupferung auch gedreht und so gleichmäßig von der unerwünschten Beschichtung befreit.

Eine entsprechend ausgebildete Entkupferungseinrichtung 79 kann auch im Bereich des Rücklauftrums 51 des oberen Förderers 20b angeordnet sein. Es ist jedoch auch möglich, andere Entkupferungseinrichtungen für die Kontaktflächen 87 der Kontaktrollen 81 vorzusehen, beispielsweise durch Abätzen in einem separaten Bad.

In Figur 6 ist eine Leiterplatte 12 dargestellt, die fast die gesamte Breite des Behandlungsraumes einnimmt. Wenn dauerhaft mit einer geringeren Breite gearbeitet wird, so kann durch eingesetzte Blenden die Arbeitsbreite verringert werden, um den Kupferauftrag auf die nichtwirksamen Kontaktflächen 87 zu verringern. Es ist aber durchaus möglich, ohne irgendwelche Umbauten Leiterplatten unterschiedlicher Größe durch die Einrichtung zu fördern. Es ist auch möglich, schmalere Leiterplatten mehrnutzig nebeneinander zu behandeln.

Die Vorrichtung nach den Figuren 5 bis 8 arbeitet wie folgt: Nach Zuführung der Leiterplatten durch die Rollenpaare 55 und die Einlaßschleuse 16 werden sie von einem der zahlreichen Kontaktrollenpaare 81 erfaßt und in den zwischen ihnen vorgesehenen Spalt 89 hineingefördert, da sich die Kontaktrollen 81 so drehen (Pfeil 93), daß sie der Leiterplatte eine zusätzliche, im dargestellten Beispiel gleichgroße, Geschwindigkeit erteilen, wie die Geschwindigkeit, mit der die Kontaktrollenpaare sich selbst bewegen. Die Leiterplatten durchlaufen also die Anlage mit der doppelten Geschwindigkeit der Endlosförderer, was deren Verschleiß und mechanischen Aufwand herabsetzt. Außerdem werden die Leiterplatten von oben und unten stets an sich ändernden Stellen kontaktiert, so daß sichergestellt ist, daß während des Durchlaufes die Leiterplatten an allen Stellen gleichmäßig und häufig kontaktiert wurden. Das Transportsystem erteilt also dem Gegenstand zwei Antriebskomponenten, von denen eine, die Fortschritts-Geschwindigkeitskomponente, der Geschwindigkeit der Förderer entspricht und die andere, die Zusatz-Geschwindigkeitskomponente, infolge der Drehung der Kontaktrollen den Gegenständen zusätzlich erteilt wird.

Wenn die Kontakträder 82 andere Durchmesser haben als Kontaktrollen selbst, wobei sie beispielsweise ihre Synchronisation über Zwischenräder erzielen könnten, kann die Zusatz-Geschwindigkeitskomponente, die die Kontaktrollen den Gegenständen 12 erteilen, auch größer oder kleiner sein, als die Fortschritts-Geschwindigkeitskomponente der Kontaktrollen durch die Behandlungskammer. Es wird in jedem Falle sichergestellt, daß im Bereich der kathodischen Abscheidung keine Maschinenteile fest zur Leiterplatte installiert sind und damit lokale Abschirmungen verursachen könnten. Die Leiterplatte selbst enthält also keinerlei von der Behandlung nicht erfaßte Stellen.

Die Rollenpaare, die ja im Bereich der miteinander zusammenwirkenden Arbeitstrume 50 der Förderer 20a, b miteinander zusammenwirken, trennen sich am Ende der Durchlaufbahn kurz vor der Auslaßschleuse 17 voneinander und die einzelnen Kontaktrollen wandern nach oben und unten in die Entkupferungsstrecken 79. Nach deren Durchlaufen fügen sie sich im Bereich der Einlaßschleuse 16 wieder zusammen und bilden ein dann kathodisch angeschlossenes Kontaktrollenpaar.

## Patentansprüche

1. Einrichtung zur Behandlung von Gegenständen (12), insbesondere Galvanisiereinrichtung (11) für Leiterplatten, auf einer im wesentlichen horizontalen Durchlaufbahn (15) durch eine Behandlungskammer (13), mit Transportmitteln (19) für den Transport der Gegenstände (12) durch ein Behandlungsmedium (14), wie eine Elektrolytlösung, und mit an den Transportmitteln (19) vorgesehenen Kontaktiermitteln (32) zur elektrischen Kontaktierung und Stromzuführung zu den Gegenständen (12), dadurch gekennzeichnet, daß die Kontaktiermittel (32) zur Kontaktierung der Gegenstände in einem mittleren Bereich der Durchlaufbahn (15) ausgebildet und angeordnet sind.

2. Einrichtung nach Anspruch 1, dadurch gekennzeichnet, daß die Kontaktiermittel (32) vor der in Durchlaufrichtung (33) vorderen Kante (63) der Gegenstände (12) in deren Durchlaufbahn (15) verlaufen, vorzugsweise zum Greifen über die in Durchlaufrichtung (33) vordere Kante (63) der Gegenstände (12) ausgebildet sind und insbesondere als Greifer ausgebildet sind, die an quer durch die Behandlungskammer (13) verlaufenden, in dieser umlaufend geführten Trägern (29) eines an seinen beiden Seiten Ketten (26) o.dgl. aufweisenden Endlosförderers (20) angeordnet sind, wobei die Träger (29) vorzugsweise als Stangen ausgebildet sind, die in Ausnehmungen (43) der synchron mit dem Endlosförderer (20) angetriebenen Rollen- bzw. Walzenpaare der Führungsmittel (21) eingreifen, wobei ggf. die Greifer einen Öffnungsmechanismus haben, der beim Durchlaufen von Öffnungsmitteln (48, 53) betätigbar ist, wobei vorzugsweise die Greifer zangenartig ausgebildet, federnd in Schließrichtung belastet und mit Betätigungsschenkeln (36) versehen sind, die von den insbesondere am Einlaß- und Auslaßbereich (45, 46) der Behandlungskammer (13) vorgesehenen, als Schrägführungen ausgebildeten Öffnungsmittel (48) zur Öffnung von Greifschenkeln (34) betätigbar sind.

3. Einrichtung nach Anspruch 1 oder 2, dadurch gekennzeichnet, daß die Gegenstände (12) im wesentlichen zentrisch zur Durchlaufbahn (15) geführt sind, vorzugsweise mit Abstand zu beiden seitlichen Kammerwandungen (27).

4. Einrichtung nach einem der vorhergehenden Ansprüche, dadurch gekennzeichnet, daß die Transportmittel (19) Führungsmittel (21) enthalten, die in der Ebene der Durchlaufbahn (15) wirksam sind und vorzugsweise als Rollen- bzw. Walzenpaare ausgebildet sind.

5. Einrichtung nach einem der vorhergehenden Ansprüche dadurch gekennzeichnet, daß die Stromzuführung über Träger (29) erfolgt, die im Seitenbereich der Behandlungskammer (13) mit Stromzuführungsmitteln, wie einer Kontaktschiene (39) zusammenwirken.

6. Einrichtung nach einem der vorhergehenden Ansprüche, dadurch gekennzeichnet, daß ein die Durchlaufbahn bestimmende Obertrum (50) der Transportmittel (19) und ein zurücklaufendes Untertrum (51) in der Behandlungskammer (13) verlaufen, wobei am Untertrum (51) eine Einrichtung zur elektrolytischen Entfernung von Beschichtung vorgesehen ist, die während des Durchlaufs auf der Durchlaufbahn (15) auf Teile des Förderers, insbesondere die Kontaktiermittel (32), aufgebracht wurden, wobei ggf. die Kontaktiermittel durch längs dem Untertrum (51) vorgesehene Öffnungsmittel (53, 54) offengehalten sind.

7. Einrichtung nach einem der vorhergehenden Ansprüche, dadurch gekennzeichnet, daß Einlaß und Auslaß der Behandlungskammer durch Walzenschleusen (16, 17) gebildet sind.

8. Einrichtung nach einem der vorhergehenden Ansprüche, dadurch gekennzeichnet, daß die Transportmittel (19) in Abhängigkeit von den dem Einlaß (16) zugeführten Gegenständen (12), vorzugsweise durch wenigstens einen auf die Gegenstände (12) ansprechenden Sensor (56) derart steuerbar sind, daß die Kontaktiermittel (32) gegenüber der Einlaufgeschwindigkeit der Gegenstände (12) zumindest soweit verlangsamt oder angehalten werden, bis der Gegenstand (12) die Kontaktiermittel erreicht hat und/oder die Gegenstände (12) vor ihrem Auslauf gegenüber den Kontaktiermittel verlangsamt oder angehalten werden, bis der betreffende Gegenstand (12) aus den Kontaktiermitteln entfernt wurde, und/ oder, daß Zuführmittel (55) vorgesehen sind, die Gegenstände (12) den Kontaktiermitteln (32) mit höherer Geschwindigkeit als die Kontaktiermittel (32) zuführen und die die Gegenstände (12) vor dem Schließen der Kontaktiermittel in diese einführen und/oder daß Entnahmemittel (60) vorgesehen sind, die die Gegenstände (12) gegenüber den Kontaktiermitteln im Auslaufbereich (46) verzögern und die Gegenstände (12) horizontal aus den geöffneten Kontaktiermitteln herausführen und/oder die Kontaktiermittel (32) und ein Träger (29), an dem sie angebracht sind, von den Transportmitteln (19) für den Rücktransport lösbar sind, wobei ggf. der Träger (29) in wechselnden Abständen an den Transportmitteln (19) anbringbar und davon wieder lösbar ist, wobei vorzugsweise Greifeinrichtungen zum Anbringen und Lösen der Träger (29) von den Transportmitteln (19) an Einlaß (45) und Auslaß (46) der Einrichtung (11) und eine dazwischen angeordnete Rückführ- und Speichereinrichtung für die Träger (29) vorgesehen sind.

9. Einrichtung nach einem der vorhergehenden Ansprüche, dadurch gekennzeichnet, daß die Kontaktiermittel (32) zum Transport der Gegenstände (12) mit höherer Geschwindigkeit als der Fortbewegungsgeschwindigkeit der Kontaktiermittel ausgebildet sind.

10. Einrichtung nach einem der vorhergehenden Ansprüche, dadurch gekennzeichnet, daß die Kontaktiermittel (32) Kontaktrollen (81) aufweisen, die von den Transportmitteln (19) längs der Durchlaufbahn (15) bewegbar sind und insbesondere den Mittelbereich der Gegenstände (12) übergreifen, wobei ggf. oberhalb und unterhalb der Durchlaufbahn (15) je ein Satz von Kontaktrollen (81) vorgesehen ist, die vorzugsweise angetrieben und miteinander gegenläufig synchronisiert sind.

11. Einrichtung nach Anspruch 10, dadurch gekennzeichnet, daß die Transportmittel (19) obere und untere Förderer (20a, 20b) enthalten, von denen die Kontaktrollen (81) bewegbar sind, die vorzugsweise parallel und synchron angetriebene Ketten- oder Riemenförderer sind, auf denen die Kontaktiermittel (32) in Trägern (29) drehbar gelagert sind.

12. Einrichtung nach einem der Ansprüche 10 oder 11 dadurch gekennzeichnet, daß die Umfangsgeschwindigkeit der Kontaktrollen (81) im wesentlichen ihrer Transportgeschwindigkeit mittels des jeweiligen Förderers (20a, 20 b) entspricht.

13. Einrichtung nach einem der Ansprüche 10 bis 13, dadurch gekennzeichnet, daß die Kontaktrollen (81) über auf wenigstens einer Kontaktschiene (39a, 39b) laufende Kontakträder (82) elektrisch kontaktiert werden, wobei vorzugsweise auch die Kontakträder (82) miteinander mechanisch synchronisiert und insbesondere als Reibund/oder Zahnräder ausgebildet sind, wobei wenigstens eine Kontaktschiene (39b) mit einer Abfederung (91) versehen ist, wobei vorzugsweise die Kontaktierung von einer Kontaktschiene aus erfolgt und die beiden Kontakträder (82) miteinander elektrisch leitend verbunden sind.

14. Einrichtung nach einem der vorhergehenden Ansprüche, dadurch gekennzeichnet, daß im Bereich der Transportmittel, vorzugsweise an wenigstens einer Rücklaufstrecke (51) wenigstens eines Endlosförderers (20), ggf. beider Förderer (20a, 20b) eine Einrichtung (79) zum elekrolytischen Entfernen von Beschichtung vorgesehen ist.

15. Einrichtung nach einem der Ansprüche 10 bis 14, dadurch gekennzeichnet, daß die Kontaktrollen (81) im Wechsel leitende und isolierende Bereiche (87, 88) enthalten, die vorzugsweise als umlaufende Umfangsbereiche ausgebildet sind, wobei ggf. die isolierenden Bereiche eine etwas geringeren Durchmesser haben können als die leitenden Kontaktbereiche.

16. Einrichtung nach einem der vorhergehenden Ansprüche, dadurch gekennzeichnet, daß die Kontaktiermittel allein die Führung der Gegenstände (12) durch die Behandlungskammer (13) übernehmen.

## Claims

1. Apparatus for the treatment of articles (12), particularly an electroplating apparatus (11) for printed circuit boards on a substantially horizontal passage path (15) through a treatment chamber (13), with conveying means (19) for conveying the articles (12) through a treatment medium (14), such as an electrolytic solution, and with contacting means (13) provided on the conveying means (19) for the electrical contacting and supply of power to the articles (12), characterized in that the contacting means are constructed and arranged in a central area of the passage path (15).

2. Apparatus according to claim 1, characterized in that the contacting means (32) run in front of the leading edge (63) of the articles (12) in the passage direction (33) and in the passage path (15) thereof, preferably for gripping the leading edge (63) of the articles (12) in the passage direction (33) and are in particular constructed as grippers, and which are located on supports (29) running transversely through the treatment chamber (13) and guided in rotary manner therein, of an endless conveyor (20) having chains (26) or the like on its two sides, the supports (29) preferably being constructed as rods, which engage in recesses (43) of the roll or roller pairs of the guide means (21) driven synchronously with the endless conveyor (20) and optionally the grippers have an opening mechanism, which is operable by opening means (48,53) on passing through and preferably the grippers have a tong-like construction, are resiliently loaded in the closing direction and are provided with operating legs (36), which are operable by opening means (48) constructed as sloping guides and in particular provided at the inlet and outlet area (45,46) of the treatment chamber (13) for opening the gripping legs (34).

3. Apparatus according to claim 1 or 2, characterized in that the articles (12) are guided substantially centrally to the passage path (15) and are preferably spaced from the two lateral chamber walls (27).

4. Apparatus according to one of the preceding claims, characterized in that the conveying means (19) contain guide means (21), which act in the plane of the passage path (15) and are preferably constructed as roll or roller pairs.

5. Apparatus according to one of the preceding claims, characterized in that the power supply takes place by means of the supports (29), which in the lateral area of the treatment chamber (13) cooperate with power supply means, such as a contact rail (39).

6. Apparatus according to one of the preceding claims, characterized in that the upper strand (50) of the conveying means (19) defining the passage path and a returning lower strand (51) run in the treatment chamber (13) and on the lower strand (51) is provided a device for the electrolytic removal of coatings, which during the passage on the passage path (15) have been applied to parts of the conveyor, particularly the contacting means (32) and optionally the contacting means are kept open by opening means (53,54) provided along the lower strand (51).

7. Apparatus according to one of the preceding claims, characterized in that the inlet and outlet of the treatment chamber are formed by roller locks (16,17).

8. Apparatus according to one of the preceding claims, characterized in that the conveying means (19) are controllable as a function of the articles (12) supplied to the inlet (16), preferably by at least one sensor (56) responding to the articles (12) in such a way that the contacting means (32) are slowed down or stopped compared with the entrance speed of the articles (12) at least until the article (12) has reached the contacting means and/or the articles (12) are slowed down or stopped prior to their exit with respect to the contacting means until the particular article (12) has been removed from the contacting means and/or that supply means (55) are provided, which supply the articles (12) to the contacting means (32) at a higher speed than said contacting means (32) and which introduce the articles (12) into the contacting means before the latter close and/or removal means (60) are provided, which slow down the articles with respect to the contacting means in the discharge area (46) and pass the articles (12) horizontally out of the opened contacting means and/or the contacting means (32) and a support (29) to which they are fitted are detachable from the conveying means (19) for the return conveying and optionally the support (29) can be fitted with varying spacings on the conveying means (19) and can be detached again therefrom and preferably gripping devices for fitting and releasing the support with respect to the conveying means (19) are provided at the inlet (45) and outlet (46) of the apparatus (11) and an interposed return and storage mechanism for the support (29).

9. Apparatus according to one of the preceding claims, characterized in that the contacting means (32) are constructed for conveying the articles (12) at a higher speed than that of the contacting means.

10. Apparatus according to one of the preceding claims, characterized in that the contacting means (32) have contact rolls (81), which are movable by the conveying means (19) along the passage path (15) and in particular engage over the central area of the articles (12) and optionally above and below the passage path is provided in each case one set of contact rolls (81), which are preferably driven and synchronized in opposition to one another.

11. Apparatus according to claim 10, characterized in that the conveying means (19) contain upper and lower conveyors (20a,20b), from which the contact rolls (81) are movable and are preferably parallel and synchronously driven chain or belt conveyors on which the contacting means (32) are mounted in rotary manner in supports (29).

12. Apparatus according to one of the claims 10 or 11, characterized in that the circumferential speed of the contact rolls (81) substantially corresponds to the conveying speed thereof by means of the particular conveyor (20a,20b).

13. Apparatus according to one of the claims 10 to 13, characterized in that the contact rolls (81) are electrically contacted by contact wheels (82) running on at least one contact rail (39a,39b), which preferably also mechanically synchronize with one another the contact wheels (82) and are in particular constructed as friction and/or gear wheels and at least one contact rail (39b) is provided with a spring suspension (91) and preferably the contacting takes place from a contact rail and both contact wheels (82) are electrically conductively connected.

14. Apparatus according to one of the preceding claims, characterized in that in the vicinity of the conveying means and preferably on at least one return section (51) of at least one endless conveyor (20) and optionally both conveyors (20a,20b), is provided a device (79) for the electrolytic removal of coatings.

15. Apparatus according to one of the claims 10 to 14, characterized in that the contact rolls (81) contain in alternating manner conductive and insulating areas (87,88), which are preferably constructed as revolving circumferential areas and optionally the insulating areas have a somewhat smaller diameter than the conductive contact areas.

16. Apparatus according to any one of the preceding claims, characterized in that the contacting means are solely responsible for guiding the articles (12) through the treatment chamber (13).

## Revendications

1. Dispositif pour le traitement d'objets (12), en particulier dispositif de métallisation (11) pour plaquettes imprimées, sur une voie de passage (15) sensiblement horizontale à travers une chambre de traitement (13), avec des moyens de transport (19) pour le transport des objets (12) à travers un fluide de traitement (14), tel qu'une solution d'électrolyte, et avec des moyens de mise en contact (32) prévus sur les moyens de transport (19) pour la mise en contact électrique et l'alimentation électrique des objets (12), **caractérisé** en ce que les moyens de mise en contact (32) pour la mise en contact des objets sont configurés et disposés dans une région médiane de la voie de passage (15).

2. Dispositif selon la revendication 1, **caractérisé** en ce que les moyens de mise en contact (32) s'étendent dans la voie de passage (15) des objets (12) devant le bord avant (63), dans la direction de passage (33), de ces derniers, sont de préférence conçus pour saisir le bord avant (63), dans la direction de passage (33), des objets (12) et sont notamment conçus comme preneurs qui sont disposés sur des supports (29), s'étendant transversalement àtravers la chambre de traitement (13) et guidés en circulation dans cette dernière, d'un transporteur sans fin (20) présentant sur ces deux côtés des chaînes (26) ou similaires, les supports (29) étant de préférence réalisés sous forme de barres qui s'engagent dans des évidements (43) des paires de rouleaux ou de cylindres, entraînés en synchronisme avec le transporteur sans fin (20), des moyens de guidage (21), les preneurs possédant éventuellement un mécanisme d'ouverture qui peut être actionné lors du passage de moyens d'ouverture (48, 53), les preneurs étant de préférence réalisés à la manière de pinces, sollicités par ressort dans la direction de fermeture et pourvus de branches d'actionnement (36) qui peuvent être actionnées, afin d'ouvrir des branches de préhension (34), par les moyens d'ouverture (48) notamment prévus dans la région d'entrée (45) et dans la région de sortie (46) de la chambre de traitement (13) et réalisés sous la forme de guides obliques.

3. Dispositif selon la revendication 1 ou 2, **caractérisé** en ce que les objets (12) sont guidés sensiblement centralement sur la voie de passage (15), de préférence à distance des deux parois latérales (27) de la chambre.

4. Dispositif selon l'une des revendications précédentes, **caractérisé** en ce que les moyens de transport (19) comprennent des moyens de guidage (21) qui sont actifs dans le plan de la voie de passage (15) et sont de préférence réalisés sous la forme de paires de rouleaux ou de cylindres.

5. Dispositif selon l'une des revendications précédentes, **caractérisé** en ce que l'alimentation électrique s'effectue par l'intermédiaire de supports (29) qui, dans la région latérale de la chambre de traitement (13), coopèrent avec des moyens d'alimentation électrique tels qu'un rail de contact (39).

6. Dispositif selon l'une des revendications précédentes, **caractérisé** en ce qu'un tronçon supérieur (50), définissant la voie de passage, et un tronçon inférieur (51), de retour, des moyens de transport (19) s'étendent dans la chambre de traitement (13), un dispositif étant prévu sur le tronçon inférieur (51) pour l'enlèvement électrolytique d'enduction ayant été appliquée sur des parties du transporteur, notamment sur les moyens de mise en contact (32), pendant le passage sur la voie de passage (15), les moyens de mise en contact étant éventuellement maintenus ouverts par des moyens d'ouverture (53, 54) prévus le long du tronçon inférieur (51).

7. Dispositif selon l'une des revendications précédentes, **caractérisé** en ce que l'entrée et la sortie de la chambre de traitement sont formées par des sas à cylindres (16, 17).

8. Dispositif selon l'une des revendications précédentes, **caractérisé** en ce que les moyens de transport (19) peuvent être commandés en fonction des objets (12) apportés à l'entrée (16), de préférence par au moins un capteur (56) réagissant aux objets (12), de telle sorte que les moyens de mise en contact (32) sont immobilisés, ou ralentis par rapport à la vitesse d'entrée des objets (12), au moins jusqu'à ce que l'objet (12) ait atteint les moyens de mise en contact, et/ou les objets (12) sont, avant leur sortie, immobilisés ou ralentis par rapport aux moyens de mise en contact jusqu'à ce que l'objet concerné (12) ait été enlevé des moyens de mise en contact, et/ou en ce que sont prévus des moyens d'alimentation (55), qui apportent les objets (12) aux moyens de mise en contact (32) à une vitesse supérieure à celle des moyens de mise en contact (32) et qui introduisent les objets (12) dans les moyens de mise en contact avant la fermeture de ces derniers, et/ou en ce que sont prévus des moyens d'enlèvement (60), qui retardent les objets (12) par rapport aux moyens de mise en contact (32) dans la région de sortie (46) et qui sortent les objets (12) horizontalement des moyens de mise en contact ouverts, et/ou les moyens de mise en contact (32) et un support (29), sur lequel ils sont montés, peuvent être détachés des moyens de transport (19) pendant le transport de retour, le support (29) pouvant éventuellement être monté sur les moyens de transport (19) puis en être à nouveau détaché à intervalles alternants, des dispositifs de préhension étant de préférence prévus à l'entrée (45) et à la sortie (46) du dispositif (11) pour monter les supports (29) sur les moyens de transport (19) et les en détacher, et un dispositif pour entreposer et renvoyer les supports (29) étant intermédiairement prévu.

9. Dispositif selon l'une des revendications précédentes, **caractérisé** en ce que les moyens de mise en contact (32) sont conçus pour transporter les objets (12) à une vitesse supérieure à la vitesse de déplacement des moyens de mise en contact.

10. Dispositif selon l'une des revendications précédentes, **caractérisé** en ce que les moyens de mise en contact (32) présentent des rouleaux de contact (81) qui peuvent être déplacés le long de la voie de passage (15) par les moyens de transport (19) et recouvrent notamment la région médiane des objets (12), un groupe respectif de rouleaux de contact (81) étant éventuellement prévu au-dessus et au-dessous de la voie de passage (15), lesdits groupes étant de préférence entraînés et synchronisés en sens contraires.

11. Dispositif selon la revendication 10, **caractérisé** en ce que les moyens de transport (19) comprennent des transporteurs supérieur et inférieur (20a, 20b) par lesquels sont déplacés les rouleaux de contact (81), transporteurs qui sont de préférence des transporteurs à chaîne ou à courroie entraînés en parallèle et en synchronisme, sur lesquels les moyens de mise en contact (32) sont montés à rotation dans des supports (29).

12. Dispositif selon la revendication 10 ou 11, **caractérisé** en ce que la vitesse circonférentielle des rouleaux de contact (81) correspond sensiblement à leur vitesse de transport au moyen du transporteur respectif (20a, 20b).

13. Dispositif selon l'une des revendications 10 à 13, **caractérisé** en ce que les rouleaux de contact (81) sont mis en contact électrique au moyen de roues de contact (82) roulant sur au moins un rail de contact (39a, 39b), les roues de contact (82) étant de préférence également mutuellement synchronisées de façon mécanique et notamment réalisées sous forme de roues à friction et/ou dentées, au moins un rail de contact (39b) étant pourvu d'une suspension élastique (91), la mise en contact s'effectuant de préférence àpartir d'un rail de contact et les deux roues de contact (82) étant mutuellement reliées en conduction électrique.

14. Dispositif selon l'une des revendications précédentes, **caractérisé** en ce qu'un dispositif (79) est prévu pour l'enlèvement électrolytique d'enduction dans la région des moyens de transport, de préférence sur au moins un tronçon de retour (51) d'au moins un transporteur sans fin (20), éventuellement des deux transporteurs (20a, 20b).

15. Dispositif selon l'une des revendications 10 à 14, **caractérisé** en ce que les rouleaux de contact (81) comprennent alternativement des régions conductrices et isolantes (87, 88) qui sont de préférence réalisées sous la forme de régions circonférentielles entourantes, les régions isolantes pouvant éventuellement présenter un diamètre légèrement inférieur à celui des régions de contact conductrices.

16. Dispositif selon l'une des revendications précédentes, **caractérisé** en ce que les moyens de mise en contact se chargent seuls du guidage des objets (12) à travers la chambre de traitement (13).
